# EUROPEAN PATENT APPLICATION

(11) **EP 4 841 897 A1**
(43) Date of publication of application: **18.11.2026**
(21) Application number: 24918085.2
(22) Date of filing: 09.09.2024
(51) Int. Cl.: H03M 13/13

(54) **INFORMATION TRANSMISSION METHOD, ELECTRONIC DEVICE AND STORAGE MEDIUM**

(30) Priority: 18.01.2024 CN 202410075205
(71) Applicant: ZTE Corporation, Shenzhen, Guangdong 518057 (CN)
(72) Inventor: DONG, Yanfei, Shenzhen, Guangdong 518057 (CN); XU, Jin, Shenzhen, Guangdong 518057 (CN); LIANG, Chulong, Shenzhen, Guangdong 518057 (CN); XU, Jun, Shenzhen, Guangdong 518057 (CN); FU, Qiang, Shenzhen, Guangdong 518057 (CN); KANG, Jian, Shenzhen, Guangdong 518057 (CN)
(74) Representative: Aipex B.V.
(86) International application number: PCT/CN2024/117713
(87) International publication number: WO 2025/152476

(57) **Abstract**

Provided are an information transmission method, an electronic device, and a storage medium. The method includes that a first node sends an encoded code block to a second node, where the code block includes an output bit sequence generated from an input bit sequence according to a preset encoding operation. The preset encoding operation solves the problem of rate matching of fast polar codes, thereby improving the decoding efficiency of the encoded code block and enhancing communication quality.

## Description

### TECHNICAL FIELD

The present application relates to the technical field of wireless communications and, in particular, to an information transmission method, an electronic device and a storage medium.

### BACKGROUND

A polar code is a capacity-achievable channel coding method and has become an encoding scheme for control channels in fifth-generation mobile communication systems. A successive cancellation (SC) algorithm is a commonly used decoding algorithm for polar codes. The decoding process of the SC algorithm may be regarded as a process of performing depth-first traversal on a binary tree, and the number of to-be-traversed nodes determines a decoding delay. A fast successive cancellation (fast-SC) algorithm is a fast decoding method for polar codes, where a polar code decoding problem with a length of N may be regarded as decoding of two subcodes each having a length of N2. Fast decoding methods exist for subcodes of particular types. Fast decoding of the subcodes of particular types in the fast-SC algorithm can effectively reduce the number of to-be-traversed nodes, thereby reducing the decoding delay of polar codes. At present, fast decoding methods for multiple types of subcodes have been proposed in the existing art, for example, Rate-0, Repetition (REP), REP-2, Parity Checked Repetition (PCR), Repeated Parity Check (RPC), Single-Parity-Check (SPC), SPC-2, and Rate-1 nodes. However, existing fast polar code encoding methods consider only code lengths that are powers of 2 rather than the rate matching of fast polar codes, hindering applications of the fast polar codes.

### SUMMARY

Embodiments of the present application provide an information transmission method, an electronic device, and a storage medium, so as to solve the problem of rate matching of fast polar codes, improve the coding efficiency of encoded code blocks, and enhance communication quality.

An embodiment of the present application provides an information transmission method. The method includes that a first node sends an encoded code block to a second node, where the code block includes an output bit sequence generated from an input bit sequence according to a preset encoding operation.

An embodiment of the present application provides an electronic device. The electronic device includes one or more processors and a memory configured to store one or more programs.

The one or more programs, when executed by the one or more processors, cause the one or more processors to perform the method according to any embodiment of the present application.

An embodiment of the present application provides a computer-readable storage medium. The computer-readable storage medium stores one or more programs which, when executed by one or more processors, cause the one or more processors to perform the method according to any embodiment of the present application.

It is to be understood that the content described in this part is neither intended to identify key or important features of embodiments of the present application nor intended to limit the scope of the present application. Other features of the present application are apparent from the description provided hereinafter.

### BRIEF DESCRIPTION OF DRAWINGS

To illustrate technical solutions in embodiments of the present application more clearly, the drawings used in the description of the embodiments are briefly described below. Apparently, the drawings described below illustrate merely part of the embodiments of the present application, and those having ordinary skill in the art may obtain other drawings based on these drawings on the premise that no creative work is done.
FIG. 1 is a flowchart of an information transmission method according to an embodiment of the present application.
FIG. 2 is another flowchart of an information transmission method according to an embodiment of the present application.
FIG. 3 is a graph of performance comparison of a polar code encoding operation according to an embodiment of the present application with another polar code encoding method.
FIG. 4 is a graph of performance comparison of a polar code encoding operation according to an embodiment of the present application with another polar code encoding method.
FIG. 5 is a diagram illustrating the structure of an information transmission apparatus according to an embodiment of the present application.
FIG. 6 is a diagram illustrating the structure of an electronic device according to an embodiment of the present application.

### DETAILED DESCRIPTION

It is to be understood that the embodiments described herein are intended to explain embodiments of the present application and not to limit the embodiments of the present application.

In the subsequent description, a word such as "module", "component", or "unit" for representing an element is used to facilitate the description of the present application and has no particular meaning in itself. Therefore, "module", "component", and "unit" may be used in combination.

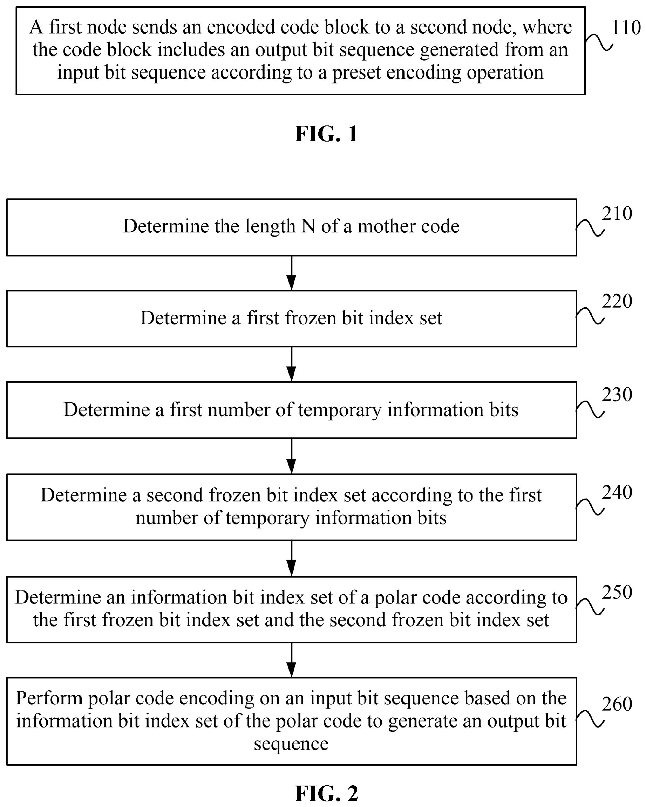

FIG. 1 is a flowchart of an information transmission method according to an embodiment of the present application. The embodiment of the present application is applicable to the transmission of polar code-encoded information. The method may be performed by an information transmission apparatus which may be implemented by software and/or hardware. Referring to FIG. 1, the method according to the embodiment of the present application includes the step below.

In step 110, a first node sends an encoded code block to a second node, where the code block includes an output bit sequence generated from an input bit sequence according to a preset encoding operation.

The preset encoding operation may be an operation for encoding the input bit sequence into the output bit sequence. The preset encoding operation may include a polar code encoding scheme. The preset encoding operation may implement rate matching of a polar code.

In the embodiment of the present application, the first node may process the input bit sequence into the output bit sequence according to the preset encoding operation. The output bit sequence may be a code block generated through polar code encoding. The first node may send the generated code block to the second node.

In some embodiments of the present application, FIG. 2 is another flowchart of an information transmission method according to an embodiment of the present application. Referring to FIG. 2, in the embodiment of the present application, generating the output bit sequence from the input bit sequence according to the preset encoding operation includes the following:
In step 210, the length N of a mother code is determined.

In the embodiment of the present application, n may be jointly determined based on parameters such as a code length E of the output bit sequence and the number K of information bits in the input bit sequence. The length N of the mother code satisfies that N = 2*ⁿ*.

In step 220, a first frozen bit index set ${\overline{Q}}_{F , tmp}^{N}$ is determined.

In the embodiment of the present application, a rate matching scheme may be determined based on parameters such as the length N of the mother code, the code length E, and the number K of information bits, and the first frozen bit index set ${\overline{Q}}_{F , tmp}^{N}$ may be determined based on the rate matching scheme. It is to be understood that the first frozen bit index set ${\overline{Q}}_{F , tmp}^{N}$ may specifically be a temporary frozen bit index set ${\overline{Q}}_{F , tmp}^{N}$.

In step 230, a first number *Kₜ* of temporary information bits is determined.

Specifically, the first number *Kₜ* of temporary information bits may be determined, which may be used for constructing the polar code. The first number *Kₜ* of temporary information bits may be jointly determined based on the parameters such as the length N of the mother code, the code length E, and the number K of information bits.

In step 240, a second frozen bit index set ${\overline{Q}}_{F , fast}^{N}$ is determined based on the first number *Kₜ* of temporary information bits.

In the embodiment of the present application, the second frozen bit index set ${\overline{Q}}_{F , fast}^{N}$ may be generated based on the first number *Kₜ* of temporary information bits, and all subcodes in the polar code determined based on the second frozen bit index set ${\overline{Q}}_{F , fast}^{N}$ can be decoded fast.

In step 250, an information bit index set ${\overline{Q}}_{I}^{N}$ of the polar code is determined based on the first frozen bit index set ${\overline{Q}}_{F , tmp}^{N}$ and the second frozen bit index set ${\overline{Q}}_{F , fast}^{N}$*.*

Specifically, the information bit index set ${\overline{Q}}_{I}^{N}$ of the polar code may be determined based on the first frozen bit index set ${\overline{Q}}_{F , tmp}^{N}$ and the second frozen bit index set ${\overline{Q}}_{F , fast}^{N}$.

In step 260, the polar code encoding is performed on the input bit sequence based on the information bit index set ${\overline{Q}}_{I}^{N}$ of the polar code to generate the output bit sequence.

In the embodiment of the present application, the polar code encoding may be performed on the input bit sequence based on the information bit index set ${\overline{Q}}_{I}^{N}$ to generate the output bit sequence corresponding to the input bit sequence. Specifically, the polar code encoding process may include acquiring the input bit sequence, performing polar encoding on the input bit sequence to obtain a bit sequence d, performing sub-block interleaving on the bit sequence d to obtain a bit sequence y, and performing bit selection on the bit sequence y to obtain the output bit sequence.

In some embodiments of the present application, that the information bit index set ${\overline{Q}}_{I}^{N}$ of the polar code is determined based on the first frozen bit index set ${\overline{Q}}_{F , tmp}^{N}$ and the second frozen bit index set ${\overline{Q}}_{F , fast}^{N}$ includes: determining a union of the first frozen bit index set ${\overline{Q}}_{F , tmp}^{N}$ and the second frozen bit index set ${\overline{Q}}_{F , fast}^{N}$, and acquiring the information bit index set ${\overline{Q}}_{I}^{N}$ corresponding to the union.

In the embodiment of the present application, the union of the first frozen bit index set ${\overline{Q}}_{F , tmp}^{N}$ and the second frozen bit index set ${\overline{Q}}_{F , fast}^{N}$ may be determined, where the union ${\overline{Q}}_{F}^{N} = {\overline{Q}}_{F , tmp}^{N} ∪ {\overline{Q}}_{F , fast}^{N}$ , and the information bit index set ${\overline{Q}}_{I}^{N}$ may be generated based on the union.

In some embodiments of the present application, acquiring the information bit index set ${\overline{Q}}_{I}^{N}$ corresponding to the union includes the following: the information bit index set ${\overline{Q}}_{I}^{N} = \left〚N\right〛 \ {\overline{Q}}_{F}^{N}$ , where $\left〚N\right〛$ represents all non-negative integers less than N, and ${\overline{Q}}_{F}^{N}$ represents the union of the first frozen bit index set ${\overline{Q}}_{F , tmp}^{N}$ and the second frozen bit index set ${\overline{Q}}_{F , fast}^{N}$.

Specifically, all the non-negative integers less than the length N of the mother code may be acquired, and the union ${\overline{Q}}_{F}^{N}$ of the frozen bit index set ${\overline{Q}}_{F , tmp}^{N}$ and the second frozen bit index set ${\overline{Q}}_{F , fast}^{N}$ may be excluded from the set composed of these non-negative integers to form a bit index set as the information bit index set ${\overline{Q}}_{I}^{N}$ .

In some embodiments of the present application, that the first number *Kₜ* of temporary information bits is determined includes: determining the rate matching scheme based on the length N of the mother code, the number K of information bits in the input bit sequence, and a sequence length E of the output bit sequence; and determining the first number *Kₜ* of temporary information bits based on the rate matching scheme.

In the embodiment of the present application, the rate matching scheme may be determined based on the length N of the mother code, the number K of information bits in the input bit sequence, and the sequence length E of the output bit sequence, and a value of the first number *Kₜ* of temporary information bits may be determined based on the determined rate matching scheme.

In some embodiments of the present application, determining the first number *Kₜ* of temporary information bits based on the rate matching scheme includes at least one of the following: in response to the rate matching scheme including repetition or puncturing, setting the first number *Kₜ* of temporary information bits to the number K of information bits; or in response to the rate matching scheme including shortening, setting the first number *Kₜ* of temporary information bits to the number K of information bits plus a difference between the length N of the mother code and the sequence length E.

In the embodiment of the present application, when the rate matching scheme is determined to be repetition or puncturing, the first number *Kₜ* of temporary information bits may be set to the number K of information bits; and when the rate matching scheme is determined to be shortening, the first number *Kₜ* of temporary information bits may be set to the number K of information bits plus the difference between the length N of the mother code and the sequence length E, that is, *Kt = N - E + K.*

For example, if E is less than N and K/E is less than or equal to 7/16, the rate matching scheme may be determined to be puncturing; if E is less than N and K/E is greater than 7/16, the rate matching scheme may be determined to be shortening; if E is greater than or equal to N, the rate matching scheme may be determined to be repetition. Correspondingly, after the rate matching scheme is determined, different rate matching schemes may correspond to different values of the first number *Kₜ* of temporary information bits. If the rate matching scheme is puncturing, *Kₜ = K.* If the rate matching scheme is shortening, *Kt = N - E + K.* If the rate matching scheme is repetition, *Kₜ = K.*

In some embodiments of the present application, determining the length N of the mother code includes determining the length N of the mother code based on the number K of information bits and the sequence length E.

In the embodiment of the present application, the length N of the mother code may be jointly determined based on the number K of information bits in the input bit sequence and the sequence length E of the output bit sequence. For example, the length N of the mother code satisfies that *N =* 2*ⁿ*, where *n* may be jointly determined based on the number K of information bits in the input bit sequence and the sequence length E of the output bit sequence.

In some example embodiments, for given parameters n with a value range that *n*ₘᵢₙ ≤ n ≤ *n*ₘₐₓ and the minimum rate *R*ₘᵢₙ, the length N of the mother code may be determined by the method below.

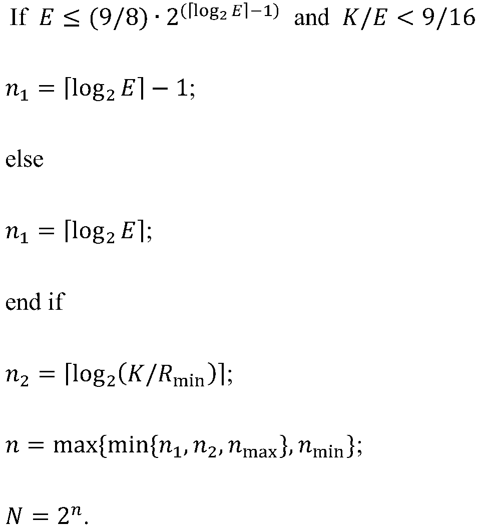

That is, if E is less than or equal to $\left(9/8\right) ⋅ {2}^{\left(\left⌈{log}_{2} E\right⌉-1\right)}$ and K/E is less than 9/16, ${n}_{1} = \left⌈{log}_{2} E\right⌉ - 1$; otherwise, ${n}_{1} = \left⌈{log}_{2} E\right⌉ ; {n}_{2} = \left⌈{log}_{2}\left(K/{R}_{min}\right)\right⌉$; and the parameter n = max{min{*n*₁, *n*₂, *n*ₘₐₓ}, *n*ₘᵢₙ}.

In some embodiments of the present application, that the second frozen bit index set ${\overline{Q}}_{F , fast}^{N}$ is determined based on the first number *Kₜ* of temporary information bits includes the following: acquiring a bit index sequence ${Q}_{0}^{N - 1}$ based on the length N of the mother code; acquiring a temporary information bit index set ${\overline{Q}}_{I , temp}^{N}$ based on the first number *Kₜ* of temporary information bits, where the temporary information bit index set ${\overline{Q}}_{I , temp}^{N}$ is composed of indexes of Kt most reliable bits in the bit index sequence ${Q}_{0}^{N - 1}$; and determining the second frozen bit index set ${\overline{Q}}_{F , fast}^{N}$ to be a set composed of bit indexes remaining after the temporary information bit index set ${\overline{Q}}_{I , temp}^{N}$ is excluded from the bit index sequence ${Q}_{0}^{N - 1}$.

In the embodiment of the present application, the bit index sequence ${Q}_{0}^{N - 1}$ may be generated based on the length N of the mother code. This bit index sequence may be a subset of a polar sequence ${Q}_{0}^{{N}_{max} - 1}$ and may be composed of all elements that are less than N in the polar sequence and sorted in ascending order of reliability. The indexes of *Kₜ* (the first number of temporary information bits) most reliable bits may be selected from the bit index sequence ${Q}_{0}^{N - 1}$ to form the temporary information bit index set ${\overline{Q}}_{I , temp}^{N}$. The set composed of bit indexes remaining after the temporary information bit index set ${\overline{Q}}_{I , temp}^{N}$ is excluded from the bit index sequence ${Q}_{0}^{N - 1}$ may be used as the second frozen bit index set ${\overline{Q}}_{F , fast}^{N}$.

Based on the preceding embodiments of the present application, the method further includes updating the temporary information bit index set ${\overline{Q}}_{I , temp}^{N}$ based on the first number *Kₜ* of temporary information bits and a polar permutation table; where the polar permutation table is composed of three groups of elements, and the three groups of elements include the number of nominal information bits, an index of a subcode with the number of to-be-reduced information bits, and an index of a subcode with the number of to-be-increased information bits, where the subcodes are obtained by sequentially dividing the mother code according to the same length.

In the embodiment of the present application, the polar permutation table may be composed of the three groups of elements, and the three groups of elements include the number of nominal information bits, the index of the subcode with the number of to-be-reduced information bits, and the index of the subcode with the number of to-be-increased information bits, where the subcodes may be obtained by sequentially dividing the mother code according to the same length. The temporary information bit index set ${\overline{Q}}_{I , temp}^{N}$ may be updated based on the first number *Kₜ* of temporary information bits and the polar permutation table.

Based on the preceding embodiments of the present application, updating the temporary information bit index set ${\overline{Q}}_{I , temp}^{N}$ based on the first number *Kₜ* of temporary information bits and the polar permutation table includes the following: determining the number of nominal information bits from the polar permutation table based on the first number *Kₜ* of temporary information bits; based on the determined number of nominal information bits, determining an information bit with the lowest reliability from the subcode with the number of to-be-reduced information bits which corresponds to the determined number of nominal information bits, and removing an index of the information bit with the lowest reliability from the temporary information bit index set ${\overline{Q}}_{I , temp}^{N}$; and based on the determined number of nominal information bits, determining a frozen bit with the highest reliability from the subcode with the number of to-be-increased information bits which corresponds to the determined number of nominal information bits, and adding an index of the frozen bit with the highest reliability to the temporary information bit index set ${\overline{Q}}_{I , temp}^{N}$.

Specifically, a process of updating the temporary information bit index set ${\overline{Q}}_{I , temp}^{N}$ based on the first number *Kₜ* of temporary information bits and the polar permutation table may include determining the number of nominal information bits from the polar permutation table based on the first number *Kₜ* of temporary information bits. For example, the number of nominal information bits that satisfies the first number *Kₜ* of temporary information bits is determined from the polar permutation table. For the subcode with the number of to-be-reduced information bits and the subcode with the number of to-be-increased information bits, which are determined to be associated with the determined number of nominal information bits, the information bit with the lowest reliability may be determined from the subcode with the number of to-be-reduced bits and the index of the information bit with the lowest reliability may be removed from the temporary information bit index set ${\overline{Q}}_{I , temp}^{N}$, and the frozen bit with the highest reliability may be determined from the subcode with the number of to-be-increased bits and the frozen bit with the highest reliability may be added to the temporary information bit index set ${\overline{Q}}_{I , temp}^{N}$, thereby implementing the update of the temporary information bit index set ${\overline{Q}}_{I , temp}^{N}$.

In some embodiments of the present application, the method further includes the following: determining a second number *Kₘ* of temporary information bits based on the union of the first frozen bit index set ${\overline{Q}}_{F , tmp}^{N}$ and the second frozen bit index set ${\overline{Q}}_{F , fast}^{N}$; updating the first number *Kₜ* of temporary information bits based on the second number *Kₘ* of temporary bits and the number K of information bits; and updating the second frozen bit index set ${\overline{Q}}_{F , fast}^{N}$ based on the updated first number *Kₜ* of temporary information bits.

Specifically, the union of the first frozen bit index set ${\overline{Q}}_{F , tmp}^{N}$ and the second frozen bit index set ${\overline{Q}}_{F , fast}^{N}$ may be determined, and the length N of the mother code minus the size of the union may be used as the second number *Kₘ* of temporary information bits. The first number *Kₜ* of temporary information bits may be updated according to a comparison result of the second number *Kₘ* of temporary information bits and the number K of information bits, and the second frozen bit index set ${\overline{Q}}_{F , fast}^{N}$ may be updated based on the updated first number *Kₜ* of temporary information bits. It is to be understood that a frozen bit index set may be re-determined based on the updated first number *Kₜ* of temporary information bits and used as the updated second frozen bit index set ${\overline{Q}}_{F , fast}^{N}$. A method for determining the frozen bit index set based on the first number *Kₜ* of temporary information bits may be the same as the process in the preceding embodiment.

In some example embodiments, when the second number *Kₘ* of temporary information bits is the same as the number K of information bits, the first number *Kₜ* of temporary information bits may not be updated; when the second number *Kₘ* of temporary information bits is different from the number K of information bits, a difference between the second number *Kₘ* of temporary information bits and the number K of information bits may be determined, and the first number *Kₜ* of temporary information bits may be increased by the difference.

In some embodiments of the present application, determining the first frozen bit index set ${\overline{Q}}_{F , tmp}^{N}$ includes at least one of the following: in response to the sequence length E of the output bit sequence being greater than the length N of the mother code, determining the first frozen bit index set ${\overline{Q}}_{F , tmp}^{N}$ to be an empty set; or determining the first frozen bit index set ${\overline{Q}}_{F , tmp}^{N}$ based on the ratio of the number K of information bits in the input bit sequence to the sequence length E.

In the embodiment of the present application, the first frozen bit index set may be jointly determined based on the number K of bits in the input bit sequence, the sequence length E of the output bit sequence, and the length N of the mother code. Specifically, when E is greater than N, the first frozen bit index set ${\overline{Q}}_{F , tmp}^{N}$ may be determined to be the empty set; otherwise, the first frozen bit index set ${\overline{Q}}_{F , tmp}^{N}$ may be determined based on the ratio of K to E, that is, a value of the rate.

In an example embodiment, when E is less than N and K/E is less than or equal to 7/16, for each *n* from 0 to N-E-1, the corresponding J(n) is determined, where J(n) = *P(i)* × (*N*/ 32) + mod(*n,N*/32), $i = \left⌊32n/N\right⌋$, and *P(i)* is a sub-block interleaver pattern and may be determined from a sub-block interleaver pattern table; and each J(n) may be separately added to the first frozen bit index set ${\overline{Q}}_{F , tmp}^{N}$. If E is greater than or equal to 3N/4, integers from 0 to $\left⌈3N/4-E/2\right⌉ - 1$ are separately added to the first frozen bit index set ${\overline{Q}}_{F , tmp}^{N}$. If E is less than 3N/4, integers from 0 to [9N/16 - *E*/*4]* - 1 are separately added to the first frozen bit index set ${\overline{Q}}_{F , tmp}^{N}$. If E is less than N and K/E is greater than 7/16, for each *n* from 0 to N-1, the corresponding J(n) is determined, and each J(n) may be separately added to the first frozen bit index set ${\overline{Q}}_{F , tmp}^{N}$.

Based on the preceding embodiments of the present application, the method further includes, based on the second number *Kₘ* of temporary information bits, determining whether a fast polar code is compatible with the rate matching scheme.

In the embodiment of the present application, the second number *Kₘ* of temporary information bits may be compared with the number K of information bits in the input bit sequence, and whether the fast polar code is compatible with the rate matching scheme may be determined according to a comparison result of *Kₘ* and K. For example, when *Kₘ* is different from K, the fast polar code is incompatible with the rate matching scheme, and the first number *Kₜ* of temporary information bits and the second frozen bit index set ${\overline{Q}}_{F , fast}^{N}$ need to be updated to obtain a polar code compatible with the rate matching scheme.

In an example embodiment, a code block encoded by the fast polar code may be transmitted in the information transmission method, and the information transmission method may include that a first node sends the encoded code block to a second node.

In the embodiment of the present application, the first node may perform a fast polar code encoding operation on an output bit sequence *c*₀, *c*₁, *c*₂, *c*₃, ..., *c*_{*K*-1} to obtain a rate-matched output bit sequence *e*₀, *e*₁, *e*₂, *e*₃, ..., *e*_{*E*-1}.

Specifically, the fast polar code encoding operation may include the following:
1. The first node determines the length N of a mother code, where N = 2*ⁿ*, and the parameter n is jointly determined based on parameters such as a sequence length E of the rate-matched output bit sequence and the number K of information bits in the input bit sequence.

In an example embodiment, the length N of the mother code may be determined through the process below.

For the given parameters n with a value range that *n*ₘᵢₙ ≤ n ≤ *n*ₘₐₓ and the minimum rate *R*ₘᵢₙ, the length N of the mother code may be determined by the method below.

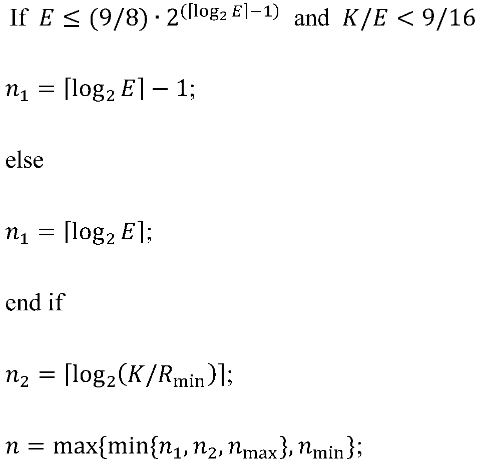

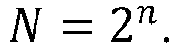

2. A temporary frozen bit index set is constructed. A rate matching scheme required for encoding may be determined based on N, E, and K, and a frozen bit index set ${\overline{Q}}_{F , tmp}^{N}$ may be determined based on the adopted rate matching scheme. The rate matching scheme mainly includes repetition, puncturing, and shortening and may be determined based on a relative size relationship between N and E and the rate R = K/E.

In an example embodiment, if the sequence length E is greater than the length N of the mother code, the temporary frozen bit index set ${\overline{Q}}_{F , tmp}^{N}$ is an empty set; otherwise, the temporary frozen bit index set ${\overline{Q}}_{F , tmp}^{N}$ is determined based on the ratio of the number K of information bits to the sequence length E. The determination process may be as follows:

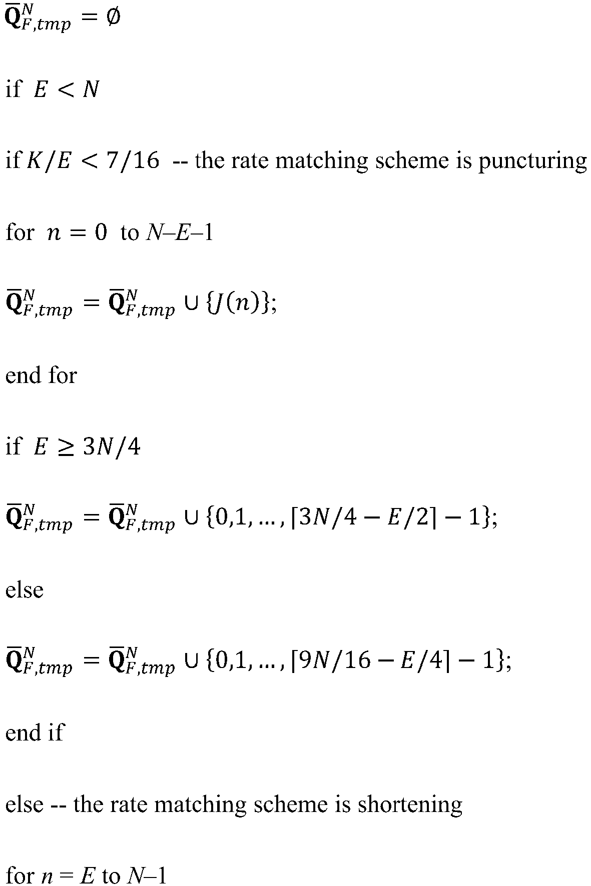

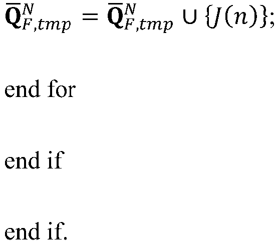

In the embodiment of the present application, *J(n) = P(i)* × *(N*/*32)* + mod(*n, N*/ 32), $i = \left⌊32n/N\right⌋$, and *P(i)* is a sub-block interleaver pattern and may be determined from a sub-block interleaver pattern table.

3. Temporary parameters for constructing the fast polar code are determined. Parameters for constructing the fast polar code may include the length N of the mother code and the number *Kₜ* of temporary information bits, where *Kₜ* is jointly determined based on the parameters N, E, and K and the rate matching scheme. When the rate matching scheme is repetition or puncturing, a fast polar code whose frozen bit indexes completely include those in the temporary frozen bit index set ${\overline{Q}}_{F , tmp}^{N}$ needs to be constructed, and the number *Kₜ* of temporary information bits satisfies that *Kt = K.* When the rate matching scheme is shortening, a fast polar code whose frozen bit index set does not completely include those in the temporary frozen bit index set ${\overline{Q}}_{F , tmp}^{N}$ needs to be constructed, and the number *Kₜ* of temporary information bits satisfies that *Kₜ = N - E + K.* For example,

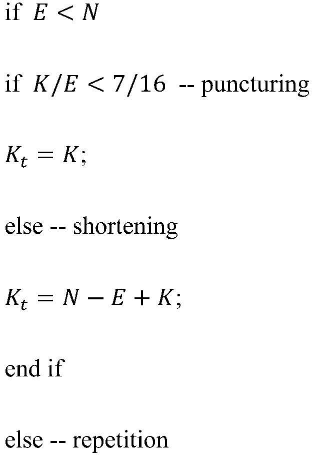

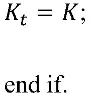

4. A second frozen bit index set ${\overline{Q}}_{F , fast}^{N}$ is determined based on the number *Kₜ* of temporary information bits. For a given polar sequence ${Q}_{0}^{{N}_{max} - 1} = \left\{{Q}_{0}^{{N}_{max}},{Q}_{1}^{{N}_{max}},{Q}_{2}^{{N}_{max}},{Q}_{3}^{{N}_{max}},…,{Q}_{{N}_{max} - 1}^{{N}_{max}}\right\}$ , elements in the polar sequence are sorted in ascending order of reliability. That is, $W \left({Q}_{0}^{{N}_{max}}\right) < W \left({Q}_{0}^{{N}_{max}}\right) < … < W \left({Q}_{{N}_{max} - 1}^{{N}_{max}}\right)$, where $W \left({Q}_{i}^{{N}_{max}}\right)$ represents the reliability of the bit index ${Q}_{i}^{{N}_{max}}$. An optional polar sequence is shown in the table below.

**Table 1 Correspondence table between bit indexes in the polar sequence and reliability**

| $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ | $W \left({Q}_{i}^{{N}_{max}}\right)$ | ${Q}_{i}^{{N}_{max}}$ |
|---|---|---|---|---|---|---|---|---|---|---|---|---|---|---|---|
| 0 | 0 | 128 | 518 | 256 | 94 | 384 | 214 | 512 | 364 | 640 | 414 | 768 | 819 | 896 | 966 |
| 1 | 1 | 129 | 54 | 257 | 204 | 385 | 309 | 513 | 654 | 641 | 223 | 769 | 814 | 897 | 755 |
| 2 | 2 | 130 | 83 | 258 | 298 | 386 | 188 | 514 | 659 | 642 | 663 | 770 | 439 | 898 | 859 |
| 3 | 4 | 131 | 57 | 259 | 400 | 387 | 449 | 515 | 335 | 643 | 692 | 771 | 929 | 899 | 940 |
| 4 | 8 | 132 | 521 | 260 | 608 | 388 | 217 | 516 | 480 | 644 | 835 | 772 | 490 | 900 | 830 |
| 5 | 16 | 133 | 112 | 261 | 352 | 389 | 408 | 517 | 315 | 645 | 619 | 773 | 623 | 901 | 911 |
| 6 | 32 | 134 | 135 | 262 | 325 | 390 | 609 | 518 | 221 | 646 | 472 | 774 | 671 | 902 | 871 |
| 7 | 3 | 135 | 78 | 263 | 533 | 391 | 596 | 519 | 370 | 647 | 455 | 775 | 739 | 903 | 639 |
| 8 | 5 | 136 | 289 | 264 | 155 | 392 | 551 | 520 | 613 | 648 | 796 | 776 | 916 | 904 | 888 |
| 9 | 64 | 137 | 194 | 265 | 210 | 393 | 650 | 521 | 422 | 649 | 809 | 777 | 463 | 905 | 479 |
| 10 | 6 | 138 | 85 | 266 | 305 | 394 | 229 | 522 | 425 | 650 | 714 | 778 | 843 | 906 | 946 |
| 11 | 9 | 139 | 276 | 267 | 547 | 395 | 159 | 523 | 451 | 651 | 721 | 779 | 381 | 907 | 750 |
| 12 | 17 | 140 | 522 | 268 | 300 | 396 | 420 | 524 | 614 | 652 | 837 | 780 | 497 | 908 | 969 |
| 13 | 10 | 141 | 58 | 269 | 109 | 397 | 310 | 525 | 543 | 653 | 716 | 781 | 930 | 909 | 508 |
| 14 | 18 | 142 | 168 | 270 | 184 | 398 | 541 | 526 | 235 | 654 | 864 | 782 | 821 | 910 | 861 |
| 15 | 128 | 143 | 139 | 271 | 534 | 399 | 773 | 527 | 412 | 655 | 810 | 783 | 726 | 911 | 757 |
| 16 | 12 | 144 | 99 | 272 | 537 | 400 | 610 | 528 | 343 | 656 | 606 | 784 | 961 | 912 | 970 |
| 17 | 33 | 145 | 86 | 273 | 115 | 401 | 657 | 529 | 372 | 657 | 912 | 785 | 872 | 913 | 919 |
| 18 | 65 | 146 | 60 | 274 | 167 | 402 | 333 | 530 | 775 | 658 | 722 | 786 | 492 | 914 | 875 |
| 19 | 20 | 147 | 280 | 275 | 225 | 403 | 119 | 531 | 317 | 659 | 696 | 787 | 631 | 915 | 862 |
| 20 | 256 | 148 | 89 | 276 | 326 | 404 | 600 | 532 | 222 | 660 | 377 | 788 | 729 | 916 | 758 |
| 21 | 34 | 149 | 290 | 277 | 306 | 405 | 339 | 533 | 426 | 661 | 435 | 789 | 700 | 917 | 948 |
| 22 | 24 | 150 | 529 | 278 | 772 | 406 | 218 | 534 | 453 | 662 | 817 | 790 | 443 | 918 | 977 |
| 23 | 36 | 151 | 524 | 279 | 157 | 407 | 368 | 535 | 237 | 663 | 319 | 791 | 741 | 919 | 923 |
| 24 | 7 | 152 | 196 | 280 | 656 | 408 | 652 | 536 | 559 | 664 | 621 | 792 | 845 | 920 | 972 |
| 25 | 129 | 153 | 141 | 281 | 329 | 409 | 230 | 537 | 833 | 665 | 812 | 793 | 920 | 921 | 761 |
| 26 | 66 | 154 | 101 | 282 | 110 | 410 | 391 | 538 | 804 | 666 | 484 | 794 | 382 | 922 | 877 |
| 27 | 512 | *155* | 147 | 283 | 117 | 411 | 313 | 539 | 712 | 667 | 430 | 795 | 822 | 923 | 952 |
| 28 | 11 | 156 | 176 | 284 | 212 | 412 | 450 | 540 | 834 | 668 | 838 | 796 | 851 | 924 | 495 |
| 29 | 40 | 157 | 142 | 285 | 171 | 413 | 542 | 541 | 661 | 669 | 667 | 797 | 730 | 925 | 703 |
| 30 | 68 | 158 | 530 | 286 | 776 | 414 | 334 | 542 | 808 | 670 | 488 | 798 | 498 | 926 | 935 |
| 31 | 130 | 159 | 321 | 287 | 330 | 415 | 233 | 543 | 779 | 671 | 239 | 799 | 880 | 927 | 978 |
| 32 | 19 | 160 | 31 | 288 | 226 | 416 | 555 | 544 | 617 | 672 | 378 | 800 | 742 | 928 | 883 |
| 33 | 13 | 161 | 200 | 289 | 549 | 417 | 774 | 545 | 604 | 673 | 459 | 801 | 445 | 929 | 762 |
| 34 | 48 | 162 | 90 | 290 | 538 | 418 | 175 | 546 | 433 | 674 | 622 | 802 | 471 | 930 | 503 |
| 35 | 14 | 163 | 545 | 291 | 387 | 419 | 123 | 547 | 720 | 675 | 627 | 803 | 635 | 931 | 925 |
| 36 | 72 | 164 | 292 | 292 | 308 | 420 | 658 | 548 | 816 | 676 | 437 | 804 | 932 | 932 | 878 |
| 37 | 257 | 165 | 322 | 293 | 216 | 421 | 612 | 549 | 836 | 677 | 380 | 805 | 687 | 933 | 735 |
| 38 | 21 | 166 | 532 | 294 | 416 | 422 | 341 | 550 | 347 | 678 | 818 | 806 | 903 | 934 | 993 |
| 39 | 132 | 167 | 263 | 295 | 271 | 423 | 777 | 551 | 897 | 679 | 461 | 807 | 825 | 935 | 885 |
| 40 | 35 | 168 | 149 | 296 | 279 | 424 | 220 | 552 | 243 | 680 | 496 | 808 | 500 | 936 | 939 |
| 41 | 258 | 169 | 102 | 297 | 158 | 425 | 314 | 553 | 662 | 681 | 669 | 809 | 846 | 937 | 994 |
| 42 | 22 | 170 | 105 | 298 | 337 | 426 | 424 | 554 | 454 | 682 | 679 | 810 | 745 | 938 | 980 |
| 43 | 513 | 171 | 304 | 299 | 550 | 427 | 395 | 555 | 318 | 683 | 724 | 811 | 826 | 939 | 926 |
| 44 | 80 | 172 | 296 | 300 | 672 | 428 | 673 | 556 | 675 | 684 | 841 | 812 | 732 | 940 | 764 |
| 45 | 37 | 173 | 163 | 301 | 118 | 429 | 583 | 557 | 618 | 685 | 629 | 813 | 446 | 941 | 941 |
| 46 | 25 | 174 | 92 | 302 | 332 | 430 | 355 | 558 | 898 | 686 | 351 | 814 | 962 | 942 | 967 |
| 47 | 26 | 175 | 47 | 303 | 579 | 431 | 287 | 559 | 781 | 687 | 467 | 815 | 936 | 943 | 886 |
| 48 | 136 | 176 | 267 | 304 | 540 | 432 | 183 | 560 | 376 | 688 | 438 | 816 | 475 | 944 | 831 |
| 49 | 260 | 177 | 385 | 305 | 389 | 433 | 234 | 561 | 428 | 689 | 737 | 817 | 853 | 945 | 947 |
| 50 | 264 | 178 | 546 | 306 | 173 | 434 | 125 | 562 | 665 | 690 | 247 | 818 | 867 | 946 | 507 |
| 51 | 38 | 179 | 324 | 307 | 121 | 435 | 557 | 563 | 736 | 691 | 462 | 819 | 637 | 947 | 889 |
| 52 | 514 | 180 | 208 | 308 | 553 | 436 | 660 | 564 | 567 | 692 | 441 | 820 | 907 | 948 | 984 |
| 53 | 96 | 181 | 386 | 309 | 199 | 437 | 616 | 565 | 840 | 693 | 442 | 821 | 487 | 949 | 751 |
| 54 | 67 | 182 | 150 | 310 | 784 | 438 | 342 | 566 | 625 | 694 | 469 | 822 | 695 | 950 | 942 |
| 55 | 41 | 183 | 153 | 311 | 179 | 439 | 316 | 567 | 238 | 695 | 251 | 823 | 746 | 951 | 996 |
| 56 | 144 | 184 | 165 | 312 | 228 | 440 | 241 | 568 | 359 | 696 | 683 | 824 | 828 | 952 | 971 |
| 57 | 28 | 185 | 106 | 313 | 338 | 441 | 778 | 569 | 457 | 697 | 842 | 825 | 753 | 953 | 890 |
| 58 | 69 | 186 | 55 | 314 | 312 | 442 | 563 | 570 | 399 | 698 | 738 | 826 | 854 | 954 | 509 |
| 59 | 42 | 187 | 328 | 315 | 704 | 443 | 345 | 571 | 787 | 699 | 899 | 827 | 857 | 955 | 949 |
| 60 | 516 | 188 | 536 | 316 | 390 | 444 | 452 | 572 | 591 | 700 | 670 | 828 | 504 | 956 | 973 |
| 61 | 49 | 189 | 577 | 317 | 174 | 445 | 397 | 573 | 677 | 701 | 783 | 829 | 799 | 957 | 1000 |
| 62 | 70 | 190 | 548 | 318 | 554 | 446 | 403 | 574 | 434 | 702 | 849 | 830 | 255 | 958 | 892 |
| 63 | 272 | 191 | 113 | 319 | 581 | 447 | 207 | 575 | 678 | 703 | 820 | 831 | 964 | 959 | 950 |
| 64 | 160 | 192 | 154 | 320 | 393 | 448 | 674 | 576 | 349 | 704 | 728 | 832 | 909 | 960 | 863 |
| 65 | 520 | 193 | 79 | 321 | 283 | 449 | 558 | 577 | 245 | 705 | 928 | 833 | 719 | 961 | 759 |
| 66 | 288 | 194 | 269 | 322 | 122 | 450 | 785 | 578 | 458 | 706 | 791 | 834 | 477 | 962 | 1008 |
| 67 | 528 | 195 | 108 | 323 | 448 | 451 | 432 | 579 | 666 | 707 | 367 | 835 | 915 | 963 | 510 |
| 68 | 192 | 196 | 578 | 324 | 353 | 452 | 357 | 580 | 620 | 708 | 901 | 836 | 638 | 964 | 979 |
| 69 | 544 | 197 | 224 | 325 | 561 | 453 | 187 | 581 | 363 | 709 | 630 | 837 | 748 | 965 | 953 |
| 70 | 73 | 198 | 166 | 326 | 203 | 454 | 236 | 582 | 127 | 710 | 685 | 838 | 944 | 966 | 763 |
| 71 | 44 | 199 | 519 | 327 | 63 | 455 | 664 | 583 | 191 | 711 | 844 | 839 | 869 | 967 | 974 |
| 72 | 131 | 200 | 552 | 328 | 340 | 456 | 624 | 584 | 782 | 712 | 633 | 840 | 491 | 968 | 954 |
| 73 | 81 | 201 | 195 | 329 | 394 | 457 | 587 | 585 | 407 | 713 | 711 | 841 | 699 | 969 | 879 |
| 74 | 50 | 202 | 270 | 330 | 527 | 458 | 780 | 586 | 436 | 714 | 253 | 842 | 754 | 970 | 981 |
| 75 | 74 | 203 | 641 | 331 | 582 | 459 | 705 | 587 | 626 | 715 | 691 | 843 | 858 | 971 | 982 |
| 76 | 15 | 204 | 523 | 332 | 556 | 460 | 126 | 588 | 571 | 716 | 824 | 844 | 478 | 972 | 927 |
| 77 | 320 | 205 | 275 | 333 | 181 | 461 | 242 | 589 | 465 | 717 | 902 | 845 | 968 | 973 | 995 |
| 78 | 133 | 206 | 580 | 334 | 295 | 462 | 565 | 590 | 681 | 718 | 686 | 846 | 383 | 974 | 765 |
| 79 | 52 | 207 | 291 | 335 | 285 | 463 | 398 | 591 | 246 | 719 | 740 | 847 | 910 | 975 | 956 |
| 80 | 23 | 208 | 59 | 336 | 232 | 464 | 346 | 592 | 707 | 720 | 850 | 848 | 815 | 976 | 887 |
| 81 | 134 | 209 | 169 | 337 | 124 | 465 | 456 | 593 | 350 | 721 | 375 | 849 | 976 | 977 | 985 |
| 82 | 384 | 210 | 560 | 338 | 205 | 466 | 358 | 594 | 599 | 722 | 444 | 850 | 870 | 978 | 997 |
| 83 | 76 | 211 | 114 | 339 | 182 | 467 | 405 | 595 | 668 | 723 | 470 | 851 | 917 | 979 | 986 |
| 84 | 137 | 212 | 277 | 340 | 643 | 468 | 303 | 596 | 789 | 724 | 483 | 852 | 727 | 980 | 943 |
| 85 | 82 | 213 | 156 | 341 | 562 | 469 | 566 | 597 | 460 | 725 | 415 | 853 | 493 | 981 | 891 |
| 86 | 56 | 214 | 87 | 342 | 286 | 470 | 244 | 598 | 249 | 726 | 485 | 854 | 873 | 982 | 998 |
| 87 | 27 | 215 | 197 | 343 | 585 | 471 | 595 | 599 | 682 | 727 | 905 | 855 | 701 | 983 | 766 |
| 88 | 97 | 216 | 116 | 344 | 299 | 472 | 189 | 600 | 573 | 728 | 795 | 856 | 931 | 984 | 511 |
| 89 | 39 | 217 | 170 | 345 | 354 | 473 | 569 | 601 | 411 | 729 | 473 | 857 | 756 | 985 | 988 |
| 90 | 259 | 218 | 61 | 346 | 211 | 474 | 676 | 602 | 803 | 730 | 634 | 858 | 860 | 986 | 1001 |
| 91 | 84 | 219 | 531 | 347 | 401 | 475 | 361 | 603 | 790 | 731 | 744 | 859 | 499 | 987 | 951 |
| 92 | 138 | 220 | 525 | 348 | 185 | 476 | 706 | 604 | 709 | 732 | 852 | 860 | 731 | 988 | 1002 |
| 93 | 145 | 221 | 642 | 349 | 396 | 477 | 589 | 605 | 365 | 733 | 960 | 861 | 823 | 989 | 893 |
| 94 | 261 | 222 | 278 | 350 | 344 | 478 | 215 | 606 | 440 | 734 | 865 | 862 | 918 | 990 | 975 |
| 95 | 29 | 223 | 281 | 351 | 586 | 479 | 786 | 607 | 628 | 735 | 693 | 863 | 874 | 991 | 894 |
| 96 | 43 | 224 | 526 | 352 | 645 | 480 | 647 | 608 | 689 | 736 | 797 | 864 | 921 | 992 | 1009 |
| 97 | 98 | 225 | 177 | 353 | 593 | 481 | 348 | 609 | 371 | 737 | 906 | 865 | 501 | 993 | 955 |
| 98 | 515 | 226 | 293 | 354 | 535 | 482 | 419 | 610 | 423 | 738 | 715 | 866 | 933 | 994 | 1004 |
| 99 | 88 | 227 | 388 | 355 | 240 | 483 | 406 | 611 | 466 | 739 | 807 | 867 | 743 | 995 | 1010 |
| 100 | 140 | 228 | 91 | 356 | 206 | 484 | 464 | 612 | 793 | 740 | 474 | 868 | 760 | 996 | 957 |
| 101 | 30 | 229 | 584 | 357 | 95 | 485 | 680 | 613 | 250 | 741 | 636 | 869 | 881 | 997 | 983 |
| 102 | 146 | 230 | 769 | 358 | 327 | 486 | 801 | 614 | 373 | 742 | 694 | 870 | 494 | 998 | 958 |
| 103 | 71 | 231 | 198 | 359 | 564 | 487 | 362 | 615 | 481 | 743 | 254 | 871 | 702 | 999 | 987 |
| 104 | 262 | 232 | 172 | 360 | 800 | 488 | 590 | 616 | 574 | 744 | 717 | 872 | 922 | 1000 | 1012 |
| 105 | 265 | 233 | 120 | 361 | 402 | 489 | 409 | 617 | 413 | 745 | 575 | 873 | 502 | 1001 | 999 |
| 106 | 161 | 234 | 201 | 362 | 356 | 490 | 570 | 618 | 603 | 746 | 913 | 874 | 876 | 1002 | 1016 |
| 107 | 576 | 235 | 336 | 363 | 307 | 491 | 788 | 619 | 366 | 747 | 798 | 875 | 847 | 1003 | 767 |
| 108 | 45 | 236 | 62 | 364 | 301 | 492 | 597 | 620 | 468 | 748 | 811 | 876 | 992 | 1004 | 989 |
| 109 | 100 | 237 | 282 | 365 | 417 | 493 | 572 | 621 | 655 | 749 | 379 | 877 | 447 | 1005 | 1003 |
| 110 | 640 | 238 | 143 | 366 | 213 | 494 | 219 | 622 | 900 | 750 | 697 | 878 | 733 | 1006 | 990 |
| 111 | 51 | 239 | 103 | 367 | 568 | 495 | 311 | 623 | 805 | 751 | 431 | 879 | 827 | 1007 | 1005 |
| 112 | 148 | 240 | 178 | 368 | 832 | 496 | 708 | 624 | 615 | 752 | 607 | 880 | 934 | 1008 | 959 |
| 113 | 46 | 241 | 294 | 369 | 588 | 497 | 598 | 625 | 684 | 753 | 486 | 881 | 882 | 1009 | 1011 |
| 114 | 75 | 242 | 93 | 370 | 186 | 498 | 601 | 626 | 710 | 754 | 866 | 882 | 937 | 1010 | 1013 |
| 115 | 266 | 243 | 644 | 371 | 646 | 499 | 651 | 627 | 427 | 755 | 723 | 883 | 963 | 1011 | 895 |
| 116 | 273 | 244 | 202 | 372 | 404 | 500 | 421 | 628 | 794 | 756 | 489 | 884 | 747 | 1012 | 1006 |
| 117 | 517 | 245 | 592 | 373 | 227 | 501 | 792 | 629 | 252 | 757 | 908 | 885 | 505 | 1013 | 1014 |
| 118 | 104 | 246 | 323 | 374 | 896 | 502 | 802 | 630 | 374 | 758 | 718 | 886 | 855 | 1014 | 1017 |
| 119 | 162 | 247 | 392 | 375 | 594 | 503 | 611 | 631 | 605 | 759 | 813 | 887 | 924 | 1015 | 1018 |
| 120 | 53 | 248 | 297 | 376 | 418 | 504 | 602 | 632 | 848 | 760 | 476 | 888 | 734 | 1016 | 991 |
| 121 | 193 | 249 | 770 | 377 | 302 | 505 | 410 | 633 | 690 | 761 | 856 | 889 | 829 | 1017 | 1020 |
| 122 | 152 | 250 | 107 | 378 | 649 | 506 | 231 | 634 | 713 | 762 | 839 | 890 | 965 | 1018 | 1007 |
| 123 | 77 | 251 | 180 | 379 | 771 | 507 | 688 | 635 | 632 | 763 | 725 | 891 | 938 | 1019 | 1015 |
| 124 | 164 | 252 | 151 | 380 | 360 | 508 | 653 | 636 | 482 | 764 | 698 | 892 | 884 | 1020 | 1019 |
| 125 | 768 | 253 | 209 | 381 | 539 | 509 | 248 | 637 | 806 | 765 | 914 | 893 | 506 | 1021 | 1021 |
| 126 | 268 | 254 | 284 | 382 | 111 | 510 | 369 | 638 | 429 | 766 | 752 | 894 | 749 | 1022 | 1022 |
| 127 | 274 | 255 | 648 | 383 | 331 | 511 | 190 | 639 | 904 | 767 | 868 | 895 | 945 | 1023 | 1023 |

Determining the second frozen bit index set ${\overline{Q}}_{F , fast}^{N}$ based on the number *Kₜ* of temporary information bits includes the following:

Firstly, a sequence ${Q}_{0}^{N - 1} = \left\{{Q}_{0}^{N},{Q}_{1}^{N},{Q}_{2}^{N},{Q}_{3}^{N},…,{Q}_{N - 1}^{N}\right\}$ is determined from the polar sequence ${Q}_{0}^{{N}_{max} - 1}$ based on the length N of the mother code. The sequence ${Q}_{0}^{N - 1}$ may be a subset of the polar sequence ${Q}_{0}^{{N}_{max} - 1}$ and may be composed of all elements less than N in the polar sequence ${Q}_{0}^{{N}_{max} - 1}$ and sorted in ascending order of reliability, where $W \left({Q}_{0}^{N - 1}\right) < W \left({Q}_{0}^{N}\right) < … < W \left({Q}_{N - 1}^{N}\right)$ .

Then, an information bit index set ${\overline{Q}}_{I}^{N}$ is acquired based on the number *Kₜ* of temporary information bits, where the information bit index set ${\overline{Q}}_{I}^{N}$ may be composed of indexes of *Kₜ* most reliable bits in the sequence ${Q}_{0}^{N - 1}$.

Finally, subcode rate adjustment is performed based on a polar permutation table to obtain the second frozen bit index set ${\overline{Q}}_{F , fast}^{N}$.

In the embodiment of the present application, the polar permutation table is composed of three columns of data, where the first column represents the current number K of information bits, the second column represents an information bit subcode index e_{I}, and the third column represents an information bit subcode index e_{F}. When N = 1024 and the subcode has a fixed length of 16, a polar permutation table *P*₁₀ is used, as shown in Table 2 below. The rate adjustment using this table can eliminate all subcodes with rates of 5/16 and 9/16.

**Table 2 Polar permutation table P₁₀ when N = 1024**

| *K* | e_{I} | e_{F} | *K* | e_{I} | e_{F} | *K* | e_{I} | e_{F} | *K* | e_{I} | e_{F} |
|---|---|---|---|---|---|---|---|---|---|---|---|
| 128 | 60 | 54 | 306 | 30 | 23 | 500 | 23 | 21 | 696 | 17 | 36 |
| 128 | 47 | 57 | 311 | 42 | 56 | 504 | 34 | 38 | 711 | 10 | 24 |
| 130 | 47 | 60 | 316 | 15 | 44 | 508 | 28 | 26 | 719 | 49 | 12 |
| 139 | 45 | 53 | 320 | 42 | 39 | 522 | 43 | 14 | 725 | 36 | 7 |
| 146 | 55 | 58 | 323 | 23 | 49 | 531 | 40 | 37 | 728 | 42 | 34 |
| 153 | 53 | 31 | 339 | 28 | 15 | 534 | 44 | 19 | 732 | 9 | 17 |
| 160 | 47 | 46 | 342 | 46 | 27 | 545 | 29 | 25 | 751 | 19 | 20 |
| 164 | 54 | 57 | 348 | 45 | 42 | 548 | 26 | 40 | 754 | 14 | 10 |
| 166 | 54 | 51 | 361 | 41 | 52 | 551 | 49 | 13 | 758 | 7 | 33 |
| 175 | 30 | 45 | 379 | 50 | 28 | 561 | 15 | 35 | 773 | 13 | 9 |
| 177 | 30 | 54 | 385 | 43 | 41 | 564 | 19 | 22 | 785 | 5 | 18 |
| 200 | 31 | 53 | 391 | 26 | 50 | 588 | 15 | 21 | 788 | 11 | 6 |
| 204 | 46 | 43 | 399 | 37 | 23 | 595 | 14 | 11 | 796 | 7 | 12 |
| 206 | 46 | 30 | 403 | 26 | 44 | 599 | 22 | 36 | 805 | 32 | 17 |
| 220 | 51 | 56 | 405 | 26 | 38 | 610 | 11 | 48 | 813 | 7 | 5 |
| 225 | 39 | 29 | 418 | 29 | 26 | 618 | 19 | 24 | 827 | 34 | 32 |
| 228 | 27 | 46 | 425 | 22 | 49 | 620 | 19 | 14 | 829 | 34 | 10 |
| 234 | 53 | 51 | 432 | 15 | 37 | 626 | 37 | 7 | 841 | 20 | 3 |
| 241 | 45 | 39 | 436 | 44 | 15 | 632 | 33 | 19 | 845 | 6 | 9 |
| 245 | 60 | 45 | 443 | 27 | 25 | 637 | 40 | 34 | 858 | 19 | 6 |
| 258 | 58 | 27 | 452 | 21 | 42 | 644 | 28 | 13 | 860 | 19 | 16 |
| 266 | 43 | 52 | 459 | 28 | 22 | 658 | 25 | 40 | 880 | 17 | 5 |
| 274 | 54 | 30 | 464 | 52 | 35 | 670 | 35 | 20 | 891 | 4 | 8 |
| 286 | 15 | 43 | 474 | 19 | 28 | 675 | 15 | 33 | 897 | 5 | 3 |
| 289 | 29 | 50 | 476 | 19 | 41 | 689 | 40 | 11 | 899 | 5 | 32 |
| 304 | 30 | 29 | 497 | 19 | 48 | 694 | 17 | 18 | | | |

Specifically, a process of performing subcode rate adjustment based on the polar permutation table to obtain the second frozen bit index set ${\overline{Q}}_{F , fast}^{N}$ may include the following: assuming that the maximum value of K that is not greater than *Kt* in the first column of the polar permutation table *P*₁₀ is located in the L-th row, a to-be-executed row range includes the *L* - D-th row to the L-th row, where D is a preset range parameter and is generally a positive integer. For each row from the L - D-th row to the L-th row in the polar permutation table, it is determined whether the e_{F}-th subcode can be decoded fast. If so, the e_{F}-th subcode is skipped; otherwise, information bits in the e*_{I}*-th subcode are adjusted to the e_{F}-th subcode such that both the e_{F}-th subcode and the e*_{I}*-th subcode can be decoded fast.

Specifically, a bit index set of the e_{F} -th subcode is **Q***_{F}* = { e_{F} × *M*, e_{F} × *M* + 1, ··· , e_{F} × *M* + 15}, and a bit index set of the e*_{I}* -th subcode is **Q***_{I}* = {e*_{I}* × *M*, e*_{I}* × *M* + 1, ···, e*_{I}* × M + 15}. An information bit index of the e_{F}-th subcode is ${\overline{Q}}_{I}^{{e}_{F}} = {\overline{Q}}_{I}^{N} ∩ \left\{{e}_{F}\times M, {e}_{F}\times M+1,⋯,{e}_{F}\times M+15\right\}$ , and an information bit index of the e*_{I}*-th subcode is ${\overline{Q}}_{I}^{{e}_{I}} = {\overline{Q}}_{I}^{N} ∩ \left\{{e}_{I}\times M, {e}_{I}\times M+1,⋯,{e}_{I}\times M+15\right\}$ . A code rate of the e_{F} -th subcode is ${R}_{F} = \left|{\overline{Q}}_{I}^{{e}_{F}}\right| / 16$ , and a bit index of the e*_{I}*-th subcode is ${R}_{I} = \left|{\overline{Q}}_{I}^{{e}_{I}}\right| / 16$.

Specifically, if the e_{F}-th subcode with a code rate of *R_{F}* can be decoded fast, the row where the e_{F}-th subcode is located is skipped; otherwise, the least reliable index in ${\overline{Q}}_{I}^{{e}_{I}}$ is removed from the information bit index set ${\overline{Q}}_{I}^{N}$, and the most reliable index in a set ${\overline{Q}}_{F}^{{e}_{F}} = {Q}_{F} \ {\overline{Q}}_{I}^{{e}_{F}}$ is added to the information bit index set ${\overline{Q}}_{I}^{N}$. The index adjustment process is repeated until both the e*_{I}*-th subcode and the e_{F}-th subcode can be decoded fast.

After the subcode rate adjustment is completed, the second frozen bit index set ${\overline{Q}}_{F , fast}^{N}$ may be denoted as ${\overline{Q}}_{F , fast}^{N} = {Q}_{0}^{N - 1} \ {\overline{Q}}_{I}^{N}$, that is, the sequence ${Q}_{0}^{N - 1}$ excluding the information bit index set ${\overline{Q}}_{I}^{N}$ is used as the second frozen bit index set ${\overline{Q}}_{F , fast}^{N}$.

5. The information bit index set ${\overline{Q}}_{I}^{N}$ of the polar code is determined based on the temporary frozen bit index set ${\overline{Q}}_{F , tmp}^{N}$ and the second frozen bit index set ${\overline{Q}}_{F , fast}^{N}$.

Specifically, a union ${\overline{Q}}_{F}^{N}$ of the temporary frozen bit index set ${\overline{Q}}_{F , tmp}^{N}$ and the second frozen bit index set ${\overline{Q}}_{F , fast}^{N}$ is determined, that is, ${\overline{Q}}_{F}^{N} = {\overline{Q}}_{F , tmp}^{N} ∪ {\overline{Q}}_{F , fast}^{N}$. The information bit index set ${\overline{Q}}_{I}^{N} = \left〚N\right〛 \ {\overline{Q}}_{F}^{N}$, where $\left〚N\right〛$ represents all non-negative integers less than N. That is, the information bit index set ${\overline{Q}}_{I}^{N}$ may be a bit index set obtained after all bit indexes in the union ${\overline{Q}}_{F}^{N}$ are removed from all the non-negative integers less than N. A size of the information bit index set ${\overline{Q}}_{I}^{N}$ is ${K}_{m} = \left|{\overline{Q}}_{I}^{N}\right|$, where *Kₘ* may be denoted as the second number of temporary information bits.

6. Whether the polar code is compatible with the rate matching scheme is detected.

The second number *Kₘ* of temporary information bits is compared with the number K of information bits in the input bit sequence to determine whether the current fast polar code is compatible with the rate matching scheme. Specifically, if *Kₘ = K,* the current fast polar code is compatible with the rate matching scheme; otherwise, the current fast polar code is incompatible with the rate matching scheme.

In the embodiment of the present application, if the rate matching scheme is puncturing, the temporary frozen bit index set ${\overline{Q}}_{F , tmp}^{N}$ is to be included in the second frozen bit index set ${\overline{Q}}_{F , fast}^{N}$, that is, ${\overline{Q}}_{F , tmp}^{N} ⊆ {\overline{Q}}_{F , fast}^{N}$, and *Kₘ = K.* If the rate matching scheme is shortening, an intersection between the temporary frozen bit index set ${\overline{Q}}_{F , tmp}^{N}$ and the second frozen bit index set ${\overline{Q}}_{F , fast}^{N}$ is empty, that is, ${\overline{Q}}_{F , tmp}^{N} ∩ {\overline{Q}}_{F , fast}^{N} = ∅$, and the parameter *Kₘ* = *K.*

In an example embodiment, a fast polar code with E = 992 and K = 864 is constructed, and the rate matching scheme is shortening. In this case, the length N of the mother code satisfies that N = 1024. The temporary frozen bit index set ${\overline{Q}}_{F , tmp}^{N} = \left\{992,993,…,1023\right\}$, and a size of this set is $\left|{\overline{Q}}_{F , tmp}^{N}\right| = 32$. Meanwhile, based on the preceding embodiments of the present application, it can be known that the number *Kₜ* of temporary information bits satisfies that *Kt* = 896. The second frozen bit index set ${\overline{Q}}_{F , fast}^{N}$ for the fast polar code (N, *Kₜ*) is {0, 1, 2, ... 30, 32, 33, ... 46, 48, ... 52, 56, 64, 65, 66, ... 78, 80, 81, 82, 84, 88, 96, 97, 98, 100, 104, 128, 129, ... 138, 144, 145, 146, 148, 152, 160, 161, 162, 164, 192, 193, 194, 256, 257, 258, 259, 260, 261, 262, 264, 265, 266, 272, 273, 274, 288, 320, 321, 384, 512, 513, 514, 515, 516, 520, 528, 544, 545, 576, 640, 768}, and a size of this set is $\left|{\overline{Q}}_{F , fast}^{N}\right| = 128$. Since the intersection between ${\overline{Q}}_{F , tmp}^{N}$ and ${\overline{Q}}_{F , fast}^{N}$ is empty, a size of ${\overline{Q}}_{F}^{N}$ is $\left|{\overline{Q}}_{F}^{N}\right| = \left|{\overline{Q}}_{F , tmp}^{N}∪{\overline{Q}}_{F , fast}^{N}\right| = \left|{\overline{Q}}_{F , tmp}^{N}\right| + \left|{\overline{Q}}_{F , fast}^{N}\right| = 160$ , and ${K}_{m} = N - \left|{\overline{Q}}_{F}^{N}\right| = 864$. Since *Kₘ* = *K,* the fast polar code *(N, Kₘ*) is compatible with the rate matching scheme.

7. When it is determined that the polar code is incompatible with the rate matching scheme, the temporary parameters for constructing the polar code are updated.

Specifically, if the fast polar code *(N, Kₘ*) is compatible with the rate matching scheme, that is, *Kₘ = K,* this step is skipped; otherwise, an offset is added to the temporary parameter *Kₜ* for constructing the fast polar code, where a value of the offset is *K - Kₘ.* Then, the steps of constructing and detecting the temporary fast polar code are re-performed.

In an example embodiment, if the fast polar code *(N, Kₘ*) is incompatible with the rate matching scheme, that is, *Kₘ* ≠ *K,* the parameter *Kₘ* is updated to *Kt = Kt + (K - Kₘ*). For example, the construction parameter is updated in the case where a fast polar code with E = 864 and K = 376 is constructed, the rate matching scheme is puncturing, and the length N of the mother code satisfies that N = 1024. The size of the information bit index set ${\overline{Q}}_{I}^{N}$ is *Kₘ* = 368. Since *Kₘ* ≠ *K,* the temporary parameter for constructing the fast polar code is updated from *Kₜ* = 376 to *Kt* = 376 + (376 - 368) = 384.

8. An input sequence u = [*u*₀*u*₁*u*₂ ··· *u*_{*N*-1}] for a polar transform is generated.

Specifically, in the sequence u = [*u*₀*u*₁*u*₂ ··· *u*_{*N*-1}], elements whose indexes belong to the information bit index set ${\overline{Q}}_{I}^{N}$ are set to c = [*c*₀, *c*₁, *c*₂, ···, *c*_{*K*-1}], and the remaining elements are set to 0. A specific setting process may be as follows:

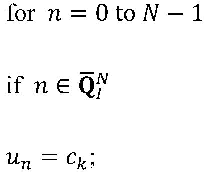

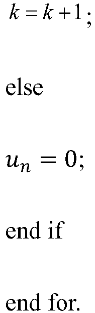

9. The polar transform is performed to obtain a sequence d = [*d*₀*d*₁*d*₂ ··· *d*_{*N*-1}]*.*

Specifically, the sequence d = [*d*₀*d*₁*d*₂ ···*d*_{*N*-1}] may be obtained according to d = **uG***_{N}*, where **G***_{N}* represents a polar transform matrix.

### 10. Sub-block interleaving

Specifically, the sub-block interleaving is performed on the bit sequence d = [*d*₀*d*₁*d*₂ ··· *d*_{*N*-1}] to obtain a sequence y = [*y*₀*y*₁*y*₂ ··· *y*_{*N*-1}]. A specific process of the sub-block interleaving may be as follows: 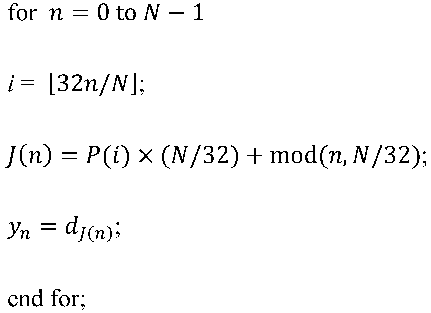 where *yₙ = d*_{*J*(*n*)} may represent that an n-th element in the sequence y is equal to a *J(n)-th* element in the sequence d. The sub-block interleaver pattern *P(i)* may be shown in Table 3 below.

**Table 3 Sub-block interleaver pattern P(i)**

| *i* | *P*(*i*) | *i* | *P*(*i*) | *i* | *P*(*i*) | *i* | *P*(*i*) | *i* | *P*(*i*) | *i* | *P*(*i*) | *i* | *P*(*i*) | *i* | *P*(*i*) |
|---|---|---|---|---|---|---|---|---|---|---|---|---|---|---|---|
| 0 | 0 | 4 | 3 | 8 | 8 | 12 | 10 | 16 | 12 | 20 | 14 | 24 | 24 | 28 | 27 |
| 1 | 1 | 5 | 5 | 9 | 16 | 13 | 18 | 17 | 20 | 21 | 22 | 25 | 25 | 29 | 29 |
| 2 | 2 | 6 | 6 | 10 | 9 | 14 | 11 | 18 | 13 | 22 | 15 | 26 | 26 | 30 | 30 |
| 3 | 4 | 7 | 7 | 11 | 17 | 15 | 19 | 19 | 21 | 23 | 23 | 27 | 28 | 31 | 31 |

### 11. Bit selection

Specifically, the sequence **y** = [*y*₀*y*₁*y*₂ ··· *y*_{*N*-1}] output by the sub-block interleaver is written into a circular buffer with a length of N to obtain the sequence e = [*e*₀,*e*₁,*e*₂,···,*e*_{*E*-1}] with a length of E. A specific implementation process may be as follows:

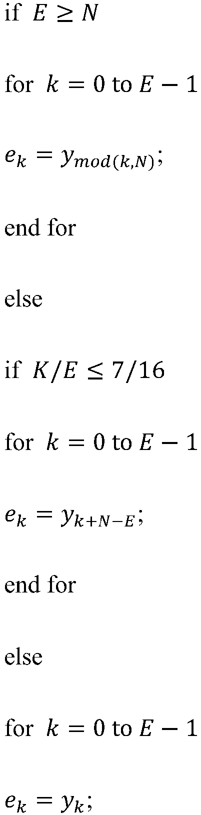

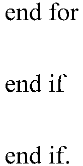

In the embodiments of the present application, as shown in Table 4, subcode distributions in polar codes with different code lengths and code rates are provided, where the subcode has a length of 16, and all the polar codes are constructed through the fast polar code matching and encoding operation in the embodiments of the present application. Assuming that only subcodes with code rates of 5/16 and 9/16 cannot be decoded fast, it can be known from Table 4 that the fast polar code matching and encoding operation in the embodiments of the present application can construct fast polar codes that satisfy rate matching schemes, completely eliminating the subcodes with code rates of 5/16 and 9/16.

**Table 4 Subcode distributions under different code lengths and code rates**

| (*E, K*) | (864, 756) | (864, 376) | (864, 173) | (640, 320) | (640, 220) | (640, 128) |
|---|---|---|---|---|---|---|
| 0 | 11 | 27 | 42 | 31 | 33 | 44 |
| 1/16 | 1 | 4 | 5 | 5 | 5 | 6 |
| 2/16 | 0 | 3 | 1 | 1 | 1 | 2 |
| 3/16 | 2 | 0 | 1 | 1 | 1 | 0 |
| 4/16 | 0 | 1 | 0 | 0 | 0 | 1 |
| 5/16 | 0 | 0 | 0 | 0 | 0 | 0 |
| 6/16 | 1 | 4 | 4 | 5 | 5 | 4 |
| 7/16 | 1 | 2 | 0 | 1 | 2 | 0 |
| 8/16 | 0 | 1 | 1 | 0 | 0 | 1 |
| 9/16 | 0 | 0 | 0 | 0 | 0 | 0 |
| 10/16 | 1 | 0 | 2 | 3 | 1 | 1 |
| 11/16 | 2 | 3 | 2 | 2 | 2 | 0 |
| 12/16 | 0 | 3 | 1 | 1 | 0 | 1 |
| 13/16 | 2 | 1 | 0 | 2 | 2 | 0 |
| 14/16 | 1 | 1 | 0 | 1 | 1 | 1 |
| 15/16 | 8 | 4 | 3 | 7 | 2 | 2 |
| 1 | 34 | 10 | 2 | 4 | 4 | 1 |

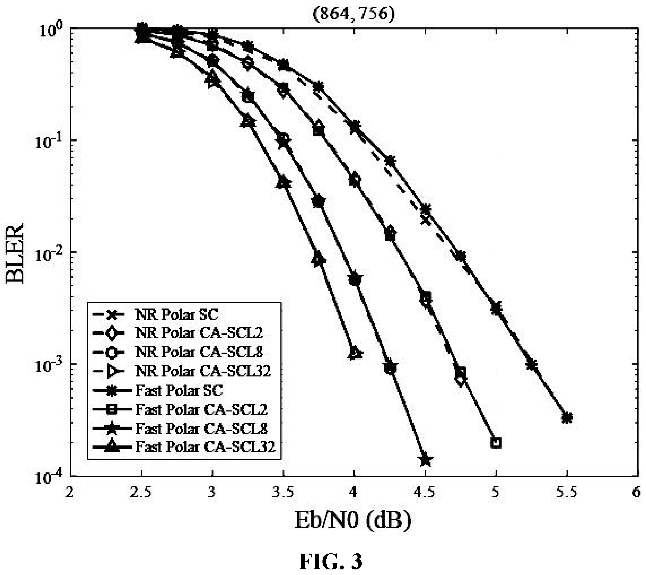

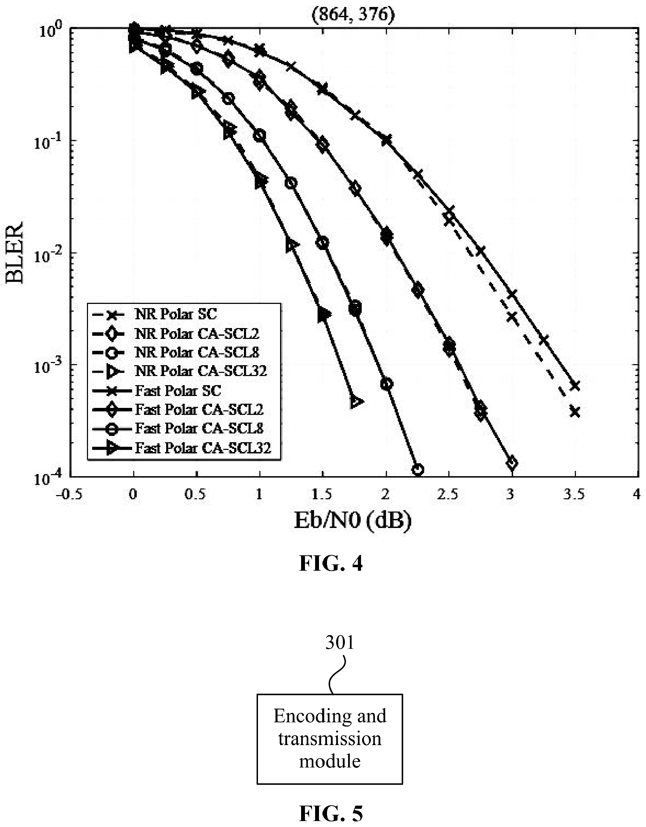

FIGS. 3 and 4 show the performance comparison of two polar codes with (864, 756) and (864, 376) under different decoding methods. It can be seen that compared with a 5G NR polar code under an SC decoding algorithm, the fast polar code operation according to the embodiments of the present application causes a performance loss within 0.1 dB. Moreover, compared with the 5G NR polar code under cyclic redundancy check aided successive cancellation list (CA-SCL) decoding algorithms, the polar code encoding operation according to the embodiments of the present application causes a negligible performance loss.

FIG. 5 is a diagram illustrating the structure of an information transmission apparatus according to an embodiment of the present application. The apparatus may perform the information transmission method according to any embodiment of the present application and has function modules and beneficial effects corresponding to the performed method. The apparatus may be implemented by software and/or hardware. As shown in FIG. 5, the apparatus according to the embodiment of the present application includes an encoding and transmission module 301.

The encoding and transmission module 301 is configured to cause a first node to send an encoded code block to a second node, where the code block includes an output bit sequence generated from an input bit sequence according to a preset encoding operation.

In some embodiments of the present application, the encoding and transmission module 301 is configured to generate the output bit sequence from the input bit sequence according to the preset encoding operation by the following method: determining the length N of a mother code; determining a first frozen bit index set ${\overline{Q}}_{F , tmp}^{N}$; determining a first number *Kₜ* of temporary information bits; determining a second frozen bit index set ${\overline{Q}}_{F , fast}^{N}$ based on the first number *Kₜ* of temporary information bits; determining an information bit index set ${\overline{Q}}_{I}^{N}$ of a polar code based on the first frozen bit index set ${\overline{Q}}_{F , tmp}^{N}$ and the second frozen bit index set ${\overline{Q}}_{F , fast}^{N}$; and performing polar code encoding on the input bit sequence based on the information bit index set ${\overline{Q}}_{I}^{N}$ of the polar code to generate the output bit sequence.

In some embodiments of the present application, determining the information bit index set ${\overline{Q}}_{I}^{N}$ of the polar code based on the first frozen bit index set ${\overline{Q}}_{F , tmp}^{N}$ and the second frozen bit index set ${\overline{Q}}_{F , fast}^{N}$ includes determining a union of the first frozen bit index set ${\overline{Q}}_{F , tmp}^{N}$ and the second frozen bit index set ${\overline{Q}}_{F , fast}^{N}$, and acquiring the information bit index set ${\overline{Q}}_{I}^{N}$ corresponding to the union.

In some embodiments of the present application, acquiring the information bit index set ${\overline{Q}}_{I}^{N}$ corresponding to the union includes the following: the information bit index set ${\overline{Q}}_{I}^{N} = \left〚N\right〛 \ {\overline{Q}}_{F}^{N}$ , where $\left〚N\right〛$ represents all non-negative integers less than N, and ${\overline{Q}}_{F}^{N}$ represents the union.

In some embodiments of the present application, determining the first number *Kₜ* of temporary information bits includes: determining a rate matching scheme based on the length N of the mother code, the number K of information bits in the input bit sequence, and a sequence length E of the output bit sequence; and determining the first number *Kₜ* of temporary information bits based on the rate matching scheme.

In some embodiments of the present application, determining the first number *Kₜ* of temporary information bits based on the rate matching scheme includes at least one of the following: in response to the rate matching scheme including repetition or puncturing, setting the first number *Kₜ* of temporary information bits to the number K of information bits; or in response to the rate matching scheme including shortening, setting the first number *Kₜ* of temporary information bits to the number K of information bits plus a difference between the length N of the mother code and the sequence length E.

In some embodiments of the present application, determining the second frozen bit index set ${\overline{Q}}_{F , fast}^{N}$ based on the first number *Kₜ* of temporary information bits includes: acquiring a bit index sequence ${Q}_{0}^{N - 1}$ based on the length N of the mother code; acquiring a temporary information bit index set ${\overline{Q}}_{I , temp}^{N}$ based on the first number *Kₜ* of temporary information bits, where the temporary information bit index set ${\overline{Q}}_{I , temp}^{N}$ is composed of indexes of Kₜ most reliable bits in the bit index sequence ${Q}_{0}^{N - 1}$; and determining the second frozen bit index set ${\overline{Q}}_{F , fast}^{N}$ to be a set composed of bit indexes remaining after the temporary information bit index set ${\overline{Q}}_{I , temp}^{N}$ is excluded from the bit index sequence ${Q}_{0}^{N - 1}$.

In some embodiments of the present application, the following is further included: updating the temporary information bit index set ${\overline{Q}}_{I , temp}^{N}$ based on the first number *Kₜ* of temporary information bits and a polar permutation table; where the polar permutation table is composed of three groups of elements, and the three groups of elements include a number of nominal information bits, an index of a subcode with the number of to-be-reduced information bits, and an index of a subcode with the number of to-be-increased information bits, where the subcodes are obtained by sequentially dividing the mother code according to the same length.

In some embodiments of the present application, updating the temporary information bit index set ${\overline{Q}}_{I , temp}^{N}$ based on the first number *Kₜ* of temporary information bits and the polar permutation table includes: determining a number of nominal information bits from the polar permutation table based on the first number *Kₜ* of temporary information bits; based on the determined number of nominal information bits, determining an information bit with the lowest reliability from the subcode with the number of to-be-reduced information bits which corresponds to the determined number of nominal information bits, and removing an index of the information bit with the lowest reliability from the temporary information bit index set ${\overline{Q}}_{I , temp}^{N}$; and based on the determined number of nominal information bits, determining a frozen bit with the highest reliability from the subcode with the number of to-be-increased information bits which corresponds to the determined number of nominal information bits, and adding an index of the frozen bit with the highest reliability to the temporary information bit index set ${\overline{Q}}_{I , temp}^{N}$.

In some embodiments of the present application, the apparatus is further configured to: determine a second number *Kₘ* of temporary information bits based on the union of the first frozen bit index set ${\overline{Q}}_{F , tmp}^{N}$ and the second frozen bit index set ${\overline{Q}}_{F , fast}^{N}$; update the first number *Kₜ* of temporary information bits based on the second number *Kₘ* of temporary bits and the number K of information bits; and update the second frozen bit index set ${\overline{Q}}_{F , fast}^{N}$ based on the updated first number *Kₜ* of temporary information bits.

In some embodiments of the present application, that the apparatus determines the first frozen bit index set ${\overline{Q}}_{F , tmp}^{N}$ includes at least one of the following: in response to the sequence length E of the output bit sequence being greater than the length N of the mother code, determining the first frozen bit index set ${\overline{Q}}_{F , tmp}^{N}$ as an empty set; or determining the first frozen bit index set ${\overline{Q}}_{F , tmp}^{N}$ based on the ratio of the number K of information bits in the input bit sequence to the sequence length E.

In some embodiments of the present application, the apparatus is further configured to, based on the second number *Kₘ* of temporary information bits, determine whether a fast polar code is compatible with the rate matching scheme.

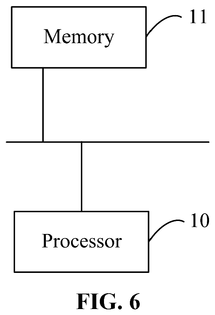

FIG. 6 is a diagram illustrating the structure of an electronic device according to an embodiment of the present application. The electronic device includes a processor 10 and a memory 11. One or more processors 10 may be provided in the electronic device, with one processor 10 shown as an example in FIG. 6. The processor 10 and the memory 11 in the electronic device may be connected via a bus or by other methods. In FIG. 6, the connection via a bus is shown as an example.

As a computer-readable storage medium, the memory 11 may be configured to store software programs, computer-executable programs, and modules, such as the module (the encoding and transmission module 301) corresponding to the apparatus in an embodiment of the present application. The processor 10 executes software programs, instructions, and modules stored in the memory 11 to perform function applications and data processing of the electronic device, that is, to perform the preceding information transmission method.

The memory 11 may mainly include a program storage region and a data storage region, where the program storage region may store an operating system and an application program required by at least one function, and the data storage region may store data created depending on use of the electronic device. Additionally, the memory 11 may include a high-speed random-access memory and may also include a nonvolatile memory such as at least one disk memory, a flash memory, or another nonvolatile solid-state memory. In some examples, the memory 11 may further include memories remotely disposed relative to the processor 10. These remote memories may be connected to the electronic device via a network. Examples of the network include, but are not limited to, the Internet, an intranet, a local area network, a mobile communication network, and a combination thereof.

An embodiment of the present application provides a storage medium including computer-executable instructions. The computer-executable instructions, when executed by a computer processor, cause the processor to perform an information transmission method. The method includes that a first node sends an encoded code block to a second node, where the code block includes an output bit sequence generated from an input bit sequence according to a preset encoding operation.

Based on the preceding embodiments of the present application, generating the output bit sequence from the input bit sequence according to the preset encoding operation includes: determining the length N of a mother code; determining a first frozen bit index set ${\overline{Q}}_{F , tmp}^{N}$; determining a first number *Kₜ* of temporary information bits; determining a second frozen bit index set ${\overline{Q}}_{F , fast}^{N}$ based on the first number *Kₜ* of temporary information bits; determining an information bit index set ${\overline{Q}}_{I}^{N}$ of a polar code based on the first frozen bit index set ${\overline{Q}}_{F , tmp}^{N}$ and the second frozen bit index set ${\overline{Q}}_{F , fast}^{N}$; and performing polar code encoding on the input bit sequence based on the information bit index set ${\overline{Q}}_{I}^{N}$ of the polar code to generate the output bit sequence.

From the preceding description of embodiments, it is apparent to those skilled in the art that the present application may be implemented by software and necessary general-purpose hardware or may be implemented by hardware, but the former is preferred in many cases. Based on this understanding, the technical solutions of the present application substantially, or the part contributing to the existing art, may be embodied in the form of a software product. The computer software product may be stored in a computer-readable storage medium such as a floppy disk, a read-only memory (ROM), a random-access memory (RAM), a flash memory, a hard disk, or an optical disk of a computer and includes several instructions to enable a computer device (which may be a personal computer, a server, or a network device) to perform the information transmission method according to any embodiment of the present application.

It is to be noted that units and modules included in the embodiments of the preceding apparatus are divided according to functional logic, and the division is not limited to this as long as the corresponding functions can be implemented. Additionally, the names of function units are intended for distinguishing between each other and are not to limit the scope of the present application.

It is to be understood by those having ordinary skill in the art that some or all steps of the preceding method and function modules/units in the preceding apparatus or device may be implemented as software, firmware, hardware, and suitable combinations thereof.

In the hardware implementation, the division of the preceding function modules/units may not correspond to the division of physical components. For example, one physical component may have multiple functions, or one function or step may be performed jointly by multiple physical components. Some or all physical components may be implemented as software executed by a processor such as a central processing unit, a digital signal processor, or a microprocessor, may be implemented as hardware, or may be implemented as integrated circuits such as application-specific integrated circuits. The corresponding software may be distributed on a computer-readable medium. The computer-readable medium may include a computer storage medium (or non-transitory medium) and a communication medium (or transitory medium). As is known to those having ordinary skill in the art, the term computer storage medium includes volatile and nonvolatile media as well as removable and non-removable media implemented in any method or technology for storing information (such as computer-readable instructions, data structures, program modules, or other data). The computer storage medium includes, but is not limited to, a RAM, a ROM, an electrically erasable programmable read-only memory (EEPROM), a flash memory or another memory technology, a compact disc read-only memory (CD-ROM), a digital video disc (DVD) or another optical disc memory, a magnetic cassette, a magnetic tape, a magnetic disk memory or another magnetic storage apparatus, or any other medium that is used for storing desired information and that can be accessed by a computer. Additionally, as is known to those having ordinary skill in the art, the communication medium generally includes computer-readable instructions, data structures, program modules, or other data in carriers or in modulated data signals transported in other transport mechanisms and may include any information delivery medium.

Preferred embodiments of the present application are described above with reference to the drawings and are not intended to limit the scope of the present application. Any modifications, equivalent substitutions, and improvements made by those skilled in the art without departing from the scope and substantive content of the present application fall within the scope of the present application.

## Claims

1. An information transmission method, comprising:
sending, by a first node, an encoded code block to a second node, wherein the code block comprises an output bit sequence generated from an input bit sequence according to a preset encoding operation.

2. The information transmission method of claim 1, wherein generating the output bit sequence from the input bit sequence according to the preset encoding operation comprises:
determining a length N of a mother code;
determining a first frozen bit index set ${\overline{Q}}_{F , tmp}^{N}$;
determining a first number *Kₜ* of temporary information bits;
determining a second frozen bit index set ${\overline{Q}}_{F , fast}^{N}$ according to the first number *Kₜ* of temporary information bits;
determining an information bit index set ${\overline{Q}}_{I}^{N}$ of a polar code according to the first frozen bit index set ${\overline{Q}}_{F , tmp}^{N}$ and the second frozen bit index set ${\overline{Q}}_{F , fast}^{N}$; and
performing polar code encoding on the input bit sequence based on the information bit index set ${\overline{Q}}_{I}^{N}$ of the polar code to generate the output bit sequence.

3. The information transmission method of claim 2, wherein determining the information bit index set ${\overline{Q}}_{I}^{N}$ of the polar code based on the first frozen bit index set ${\overline{Q}}_{F , tmp}^{N}$ and the second frozen bit index set ${\overline{Q}}_{F , fast}^{N}$ comprises:
determining a union of the first frozen bit index set ${\overline{Q}}_{F , tmp}^{N}$ and the second frozen bit index set ${\overline{Q}}_{F , fast}^{N}$, and acquiring the information bit index set ${\overline{Q}}_{I}^{N}$ corresponding to the union.

4. The information transmission method of claim 3, wherein acquiring the information bit index set ${\overline{Q}}_{I}^{N}$ corresponding to the union comprises the following:
the information bit index set ${\overline{Q}}_{I}^{N} = \left〚N\right〛 \ {\overline{Q}}_{F}^{N}$, wherein $\left〚N\right〛$ represents all non-negative integers less than N, and ${\overline{Q}}_{F}^{N}$ represents the union.

5. The information transmission method of claim 2, wherein determining the first number *Kₜ* of temporary information bits comprises:
determining a rate matching scheme based on the length N of the mother code, a number K of information bits in the input bit sequence, and a sequence length E of the output bit sequence; and
determining the first number *Kₜ* of temporary information bits based on the rate matching scheme.

6. The information transmission method of claim 5, wherein determining the first number *Kₜ* of temporary information bits based on the rate matching scheme comprises at least one of:
in response to the rate matching scheme comprising repetition or puncturing, setting the first number *Kₜ* of temporary information bits to the number K of information bits; or
in response to the rate matching scheme comprising shortening, setting the first number *Kₜ* of temporary information bits to the number K of information bits plus a difference between the length N of the mother code and the sequence length E.

7. The information transmission method of claim 2, wherein determining the second frozen bit index set ${\overline{Q}}_{F , fast}^{N}$ based on the first number *Kₜ* of temporary information bits comprises:
acquiring a bit index sequence ${Q}_{0}^{N - 1}$ based on the length N of the mother code;
acquiring a temporary information bit index set ${\overline{Q}}_{I , temp}^{N}$ based on the first number *Kₜ* of temporary information bits, wherein the temporary information bit index set ${\overline{Q}}_{I , temp}^{N}$ is composed of indexes of Kₜ most reliable bits in the bit index sequence ${Q}_{0}^{N - 1}$; and
determining the second frozen bit index set ${\overline{Q}}_{F , fast}^{N}$ to be a set composed of bit indexes remaining after the temporary information bit index set ${\overline{Q}}_{I , temp}^{N}$ is excluded from the bit index sequence ${Q}_{0}^{N - 1}$.

8. The information transmission method of claim 7, further comprising:
updating the temporary information bit index set ${\overline{Q}}_{I , temp}^{N}$ based on the first number *Kₜ* of temporary information bits and a polar permutation table;
wherein the polar permutation table is composed of three groups of elements, and the three groups of elements comprise a number of nominal information bits, an index of a subcode with a number of to-be-reduced information bits, and an index of a subcode with a number of to-be-increased information bits, wherein subcodes are obtained by sequentially dividing the mother code according to a same length.

9. The information transmission method of claim 8, wherein updating the temporary information bit index set ${\overline{Q}}_{I , temp}^{N}$ based on the first number *Kₜ* of temporary information bits and the polar permutation table comprises:
determining the number of nominal information bits from the polar permutation table based on the first number *Kₜ* of temporary information bits;
based on the determined number of nominal information bits, determining an information bit with lowest reliability from the subcode with the number of to-be-reduced information bits which corresponds to the determined number of nominal information bits, and removing an index of the information bit with the lowest reliability from the temporary information bit index set ${\overline{Q}}_{I , temp}^{N}$; and
based on the determined number of nominal information bits, determining a frozen bit with highest reliability from the subcode with the number of to-be-increased information bits which corresponds to the determined number of nominal information bits, and adding an index of the frozen bit with the highest reliability to the temporary information bit index set ${\overline{Q}}_{I , temp}^{N}$.

10. The information transmission method of claim 2, further comprising:
determining a second number *Kₘ* of temporary information bits based on a union of the first frozen bit index set ${\overline{Q}}_{F , tmp}^{N}$ and the second frozen bit index set ${\overline{Q}}_{F , fast}^{N}$;
updating the first number *Kₜ* of temporary information bits based on the second number *Kₘ* of temporary bits and a number K of information bits; and
updating the second frozen bit index set ${\overline{Q}}_{F , fast}^{N}$ according to the updated first number *Kₜ* of temporary information bits.

11. The information transmission method of claim 2, wherein determining the first frozen bit index set ${\overline{Q}}_{F , tmp}^{N}$ comprises at least one of:
in response to a sequence length E of the output bit sequence being greater than the length N of the mother code, determining the first frozen bit index set ${\overline{Q}}_{F , tmp}^{N}$ as an empty set; or
determining the first frozen bit index set ${\overline{Q}}_{F , tmp}^{N}$ based on a ratio of a number K of information bits in the input bit sequence to a sequence length E of the output bit sequence.

12. The information transmission method of claim 10, further comprising:
based on the second number *Kₘ* of temporary information bits, determining whether a fast polar code is compatible with a rate matching scheme.

13. An electronic device, comprising:
at least one processor; and
a memory configured to store at least one program;
wherein the at least one program, when executed by the at least one processor, causes the at least one processor to perform the information transmission method of any one of claims 1 to 12.

14. A computer-readable storage medium storing at least one program executed by at least one processor to cause the at least one processor to perform the information transmission method of any one of claims 1 to 12.
